# EUROPÄISCHE PATENTSCHRIFT

(11) **EP 1 527 485 B1**
(45) Veröffentlichungstag und Bekanntmachung des Hinweises auf die Patenterteilung: **30.05.2007**
(21) Anmeldenummer: 03783946.1
(22) Anmeldetag: 31.07.2003
(51) Int. Cl.: H01L 41/09, H01L 41/083, H01L 41/24

(54) **PIEZOAKTOR UND VERFAHREN ZUM HERSTELLEN DES PIEZOAKTORS**
PIEZOACTUATOR AND METHOD FOR PRODUCTION OF THE PIEZOACTUATOR
ACTIONNEUR PIEZOELECTRIQUE ET PROCEDE DE FABRICATION DE CET ACTIONNEUR PIEZOELECTRIQUE

(30) Priorität: 31.07.2002 DE 10234917
(43) Veröffentlichungstag der Anmeldung: 04.05.2005
(73) Patentinhaber: SIEMENS AKTIENGESELLSCHAFT, 80333 München (DE)
(72) Erfinder: LUBITZ, Karl, 85521 Ottobrunn (DE); WOLFF, Andreas, 81825 München (DE); MURMANN-BIESENECKER, Hedwig, 96277 Schneckenlohe (DE)
(86) Internationale Anmeldenummer: PCT/DE2003/002586
(87) Internationale Veröffentlichungsnummer: WO 2004/015789

(56) Entgegenhaltungen:
- EP-A- 0 954 037
- DE-A- 3 916 539

## Beschreibung

Die Erfindung betrifft einen Piezoaktor mit mindestens einem stapelförmigen Piezoelement, das mindestens zwei entlang einer Stapelrichtung des Piezoelements übereinander angeordnete Elektrodenschichten und mindestens eine jeweils zwischen zwei Elektrodenschichten angeordnete piezoelektrische Schicht aufweist, und mindestens einer Vorspannvorrichtung zur Krafteinleitung in ein Volumen der piezoelektrischen Schicht über mindestens eine Krafteinleitungsfläche der piezoelektrischen Schicht, die an mindestens einem der Vorspannvorrichtung zugekehrten Oberflächenabschnitt der piezoelektrischen Schicht angeordnet ist. Daneben wird ein Verfahren zum Herstellen des Piezoaktors angegeben.

Ein Piezoaktor der genannten Art ist aus US 6 274 967 B1 bekannt. Der Piezoaktor weist ein Piezoelement in Vielschichtbauweise auf. Bei einem derartigen Piezoelement sind viele Elektrodenschichten und piezoelektrische Schichten abwechselnd übereinander gestapelt. Die piezoelektrischen Schichten bestehen aus einem piezokeramischen Material. Die Vorspannvorrichtung zur Krafteinleitung in das jeweilige Volumen der einzelnen piezoelektrischen Schichten besteht aus einem hohlzylindrisches Federelement, einem Aktordeckel und einem Aktorboden. Das Piezoelement ist mit seinen zwei Stirnflächen zwischen dem Aktordeckel und dem Aktorboden mit Hilfe des Federelements vorgespannt. Mit Hilfe der Vorspannvorrichtung wird in ein Gesamtvolumen jeder der piezoelektrischen Schichten eine Kraft eingeleitet. Die piezoelektrischen Schichten werden mit einer einachsigen Druckspannung entlang der Stapelrichtung beaufschlagt. Die eingeleitete Kraft bzw. die eingeleitete Druckspannung führt zur einem Domänenumschalten. Die Polarisation der Domänen werden bevorzugt quer zur Krafteinleitungsrichtung bzw. Stapelrichtung orientiert.

Zur Krafteinleitung in das Gesamtvolumen jeder der piezoelektrischen Schichten weist jede der piezoelektrischen Schichten von einander abgekehrte Oberflächenabschnitte auf, die parallel zu den Stirnflächen des Piezoelements ausgerichtet sind. Diese Oberflächenabschnitte sind entweder dem Aktordeckel oder dem Aktorboden der Vorspannvorrichtung zugekehrt. Die Oberflächenabschnitte sind so groß wie die Stirnflächen des Piezoelements. Über jeweils den gesamten Oberflächenabschnitt der piezoelektrischen Schicht kommt es zur Krafteinleitung in das Gesamtvolumen der piezoelektrischen Schicht.

Der bekannte Piezoaktor wird beispielsweise zur Ansteuerung eines Einspritzventils in einem sogenannten Common Rail Einspritzsystem eingesetzt. Dabei ist es erforderlich, dass sowohl eine bestimmte Auslenkung als auch eine bestimmte Kraft entlang der Stapelrichtung übertragen werden kann.

Ein Maß für eine Auslenkbarkeit des piezoelektrischen Materials in Richtung einer angelegten elektrischen Feldstärke ist die sogenannte piezoelektrische Ladungskonstante d₃₃. Um eine relativ große Auslenkung zu erzielen, wird beispielsweise bei einem gegebenen d₃₃-Wert die Gesamthöhe des Piezoelements vergrößert. Alternativ dazu kann eine relativ große Auslenkung durch Einleiten einer Kraft bzw. einer einachsigen Druckspannung entlang der Stapelrichtung des Piezoelements erzielt werden. Dazu werden beispielsweise in einem unpolarisierten Piezoelement die statistisch verteilten ferroelektrischen Domänen über einen sogenannten ferroelastischen Prozess bevorzugt quer zur angelegten Druckspannung bzw. quer zur Stapelrichtung geschaltet. Dies führt zu einer bleibenden Verkürzung des Piezoelements. Dieses verkürzte Piezoelement wird elektrisch angesteuert. Durch Anlegen eines elektrischen Feldes parallel zur Stapelrichtung kommt es zum Domänenschalten mit einer Vorzugsrichtung parallel zum angelegten elektrischen Feld. Es werden im Vergleich zum Piezoelement ohne Druckvorspannung wesentlich mehr Domänen umgeschaltet. Es resultiert damit eine im Vergleich zum Piezoelement ohne Druckvorspannung höhere Auslenkung des Piezoelements in Stapelrichtung.

Um auf diese Weise eine erhöhte Auslenkung in einem stapelförmigen Piezoelement in monolithischer Vielschichtbauweise erzielen zu können, wäre beispielsweise bei einer Grundfläche des Piezoelements von 1 x 1 mm² eine Kraft von über 100 N nötig. Bei einer Grundfläche von 5 x 5 mm² wäre eine Kraft von etwa 2,5 kN nötig. Dies lässt sich nur mit Hilfe einer steifen Feder mit entsprechender Einbusse an Leerlaufauslenkung bewerkstelligen.

Die Erhöhung der Auslenkung mit Hilfe der Druckvorspannung ist aber nicht nur für Piezoaktoren im Makromaßstab problematisch. Insbesondere zur Realisierung eines Piezoaktors mit relativ großer Auslenkung und Kraftübersetzung im Mikromaßstab ist die Erhöhung der Auslenkung mit Hilfe der Druckvorspannung nicht geeignet.

Aufgabe der vorliegenden Erfindung ist es, einen Aktor bereitzustellen, der als Mikroaktor einsetzbar ist und der eine im Vergleich zum bekannten Stand der Technik sehr große relative Auslenkung aufweist.

Die Aufgabe wird durch einen Piezoaktor gelöst mit mindestens einem stapelförmigen Piezoelement, das mindestens zwei entlang einer Stapelrichtung des Piezoelements übereinander angeordnete Elektrodenschichten und mindestens eine jeweils zwischen zwei Elektrodenschichten angeordnete piezoelektrische Schicht aufweist, und mindestens einer Vorspannvorrichtung zur Krafteinleitung in ein Volumen der piezoelektrischen Schicht über mindestens eine Krafteinleitungsfläche der piezoelektrischen Schicht, die an mindestens einem der Vorspannvorrichtung zugekehrten Oberflächenabschnitt der piezoelektrischen Schicht angeordnet ist. Der Piezoaktor ist dadurch gekennzeichnet, dass die Krafteinleitungsfläche kleiner ist als der Oberflächenabschnitt der piezoelektrischen Schicht und dass das Volumen ein Teilvolumen der piezoelektrischen Schicht ist. Dieses Teilvolumen ist aktorisch wirksam.

Zur Lösung der Aufgabe wird auch ein Verfahren zum Herstellen des Piezoaktors durch Einleiten einer Kraft in ein Teilvolumen der piezoelektrischen Schicht über die Krafteinleitungsfläche der piezoelektrischen Schicht angegeben. Die Kraft wird derart eingeleitet, dass in dem Teilvolumen der piezoelektrischen Schicht eine Polarisation quer zur Stapelrichtung erzeugt wird. Die Polarisation der Domänen des Teilvolumens werden bevorzugt quer zur Stapelrichtung orientiert. Es wird das aktorisch wirksame Teilvolumen erzeugt.

Vorzugsweise befindet sich das Piezoelement in einem nicht elektrisch angesteuerten Zustand. Es ist kein elektrisches Feld angelegt. Durch die Vorspannvorrichtung wird entlang der Stapelrichtung mittelbar über die Krafteinleitungsflächen eine lokal begrenzte Kraft bzw. lokal begrenzte mechanische Druckspannung in ein Teilvolumen der piezoelektrischen Schicht eingeleitet. Durch diese mechanische Druckspannung werden die in einer unpolarisierten piezoelektrisch Schicht statistisch verteilten oder in einer normal polarisierten piezoelektrischen Schicht parallel zur Druckeinleitung orientierten ferroelektrischen Domänen des Teilvolumens der piezoelektrischen Schicht in eine Vorzugsrichtung quer zur angelegten mechanischen Druckspannung geschaltet. Dies führt zu einer bleibenden Verformung beziehungsweise Verkürzung der piezoelektrischen Schicht im Bereich des Teilvolumens. Eine Schichtdicke der piezoelektrischen Schicht ist verkleinert. Es resultiert ein verformtes beziehungsweise verkürztes Piezoelement.

Wird das so erzeugte Piezoelement in Polungsrichtung (parallel zur Stapelrichtung) mit einer elektrischen Feldstärke angesteuert, werden alle Domänen sowohl innerhalb als auch außerhalb des Teilvolumens der piezoelektrischen Schicht näherungsweise parallel zur Polungsrichtung geschaltet. Bei diesem Schaltprozess bleibt der Piezoaktor im Bereich des Teilvolumens der piezoelektrischen Schicht unter Druckspannung. Allerdings wird eine erhöhte Auslenkung in Stapelrichtung des Piezoelements gemessen. Die erhöhte Auslenkung ist das Ergebnis eines erhöhten d₃₃-Werts.

In einer besonderen Ausgestaltung sind mehrere Krafteinleitungsflächen derart über die piezoelektrische Schicht verteilt, dass es durch die Krafteinleitung zu einer Verbiegung der piezoelektrischen Schicht kommt. Beispielsweise ist die piezoelektrische Schicht eine piezokeramische Schicht aus Bleizirkonattitanat. Die durch die Krafteinleitung initiierte Verbiegung resultiert aus einer elastischen Durchbiegung der piezoelektrischen Schicht. Bei geeigneter Abstimmung der Krafteinleitungsflächen, einer Schichtdicke der piezokeramischen Schicht und der eingeleiteten Kraft kann die elastische Durchbiegung durch eine ferroelastische Durchbiegung überlagert sein. Ein an der Vorspannvorrichtung messbarer Hub setzt sich aus einer Verringerung der Durchbiegung, einer Erhöhung der Schichtdicke der piezokeramischen Schicht durch 90°-Domänenschalten und einer Erhöhung der Schichtdicke durch den normalen Piezoeffekt zusammen. Bezogen auf eine Ausgangsschichtdicke der piezoelektrischen Schicht werden beispielsweise bei einer Feldstärke von 1 kV/mm d₃₃-Werte von bis zu 15.000 pm/V gemessen. Dies entspricht einer Huberhöhung um einen Faktor 10 gegenüber bisherigen Aktorlö sungen.

In einer besonderen Ausgestaltung wird ein Teilvolumen verwendet, das sich entlang einer gesamten Schichtdicke der piezoelektrischen Schicht erstreckt. Es wird ein Teilvolumen erzeugt, das sich von einem Oberflächenabschnitt der piezoelektrischen Schicht zum anderen Oberflächenabschnitt erstreckt. Das Teilvolumen durchsetzt die piezoelektrische Schicht vollständig in Dickenrichtung.

Vorzugsweise wird in diesem Teilvolumen eine im Wesentlichen vollständige Polarisation quer zur Stapelrichtung erzeugt. Es wird im Teilvolumen mit Hilfe der mechanischen Druckspannung eine nahezu vollständige Domänenumschaltung quer zur einleitenden Druckspannung erreicht oder überschritten. Die dazu aufzubringende Druckspannung hängt dabei vom verwendeten piezoelektrischen Material der piezoelektrischen Schicht ab. Die Druckspannung ist beispielsweise um so niedriger, je niedriger die Curie-Temperatur T_{C} oder je niedriger die Koerzitivfeldstärke E_{C} des piezoelektrischen Materials ist.

In einer besonderen Ausgestaltung weisen die Vorspannvorrichtung und/oder das Piezoelement zur Erzeugung der Krafteinleitungsfläche mindestens eine aus der Gruppe Kugelkalotte (Kugelkappe), Kegelstumpf, Quader, Ring und/oder Zylinder ausgewählte Bauform auf. Denkbar ist auch ein Prisma. Diese Bauformen ermöglichen insbesondere die Realisierung sowohl von punktförmigen als auch von streifenförmigen Krafteinleitungsflächen. Punktförmig bedeutet dabei, dass die Krafteinleitungsfläche durch eine kreisförmige oder näherungsweise kreisförmige Fläche beschrieben werden kann. Die Krafteinleitungsfläche kann dabei, wie im Fall des Ringes, sowohl kreisrund, oval oder quadratisch sein. Beispielsweise verfügt die Vorspannvorrichtung über einen Stempel in Form eines Quaders mit einer quadratischen Grundfläche öder in Form eines Zylinders mit einer runden Grundfläche. Über diese Grundflächen wird die mechanische Druckvorspannung auf das Piezoelement übertragen. Der Grundfläche des Stempels entsprechend wird dabei die mechanische Druckvorspannung über eine runde oder quadratische Krafteinleitungsfläche der piezoelektrischen Schicht in das Teilvolumen der piezoelektrischen Schicht eingeleitet. Weist der Quader eine rechteckige Grundfläche auf, wird die Kraft entlang einer streifenförmigen Krafteinleitungsfläche in ein entsprechend geformtes Teilvolumen der piezoelektrischen Schicht eingeleitet. Denkbar ist auch, dass bei einem Zylinder die Kraft nicht über eine Grundfläche, sondern über eine Mantelfläche eingeleitet wird. Dabei liegt beispielsweise eine linienförmige Krafteinleitungsfläche vor.

Denkbar ist auch, dass die Krafteinleitungsflächen mit Hilfe einer strukturierten Elektrodenschicht des Piezoelements realisiert sind. Mit Hilfe der strukturierten Elektrodenschichten wird in die piezoelektrische Schicht nur an bestimmten Stellen die Kraft eingeleitet. Nur an diesen Stellen kommt es in Folge der Krafteinleitung zu einem Domänenumschalten. Zur Strukturierung der Elektrodenschicht sind alle bekannten Verfahren aus der Mikrostrukturierung anwendbar.

In einer besonderen Ausgestaltung wird eine Vielzahl von Teilvolumina in der piezoelektrischen Schicht erzeugt. Die Teilvolumina sind dabei vorzugsweise voneinander getrennt. Dies bedeutet, dass über mehrere Krafteinleitungsflächen in der piezoelektrischen Schicht das Umschalten der Polarisation der Domänen quer zur Stapelrichtung erzeugt wird. Die über die Krafteinleitungsflächen eingeleitete Druckspannung ist dabei vorzugsweise gleich. Dies bedeutet beispielsweise, dass bei gleicher Größe der Krafteinleitungsflächen jeweils eine gleiche Kraft über die Vorspannvorrichtung auf die Krafteinleitungsflächen ausgeübt wird.

Insbesondere sind mindestens drei Krafteinleitungsflächen vorhanden, die über den Oberflächenabschnitt der piezoelektrischen Schicht flächig verteilt sind. Bei drei flächig verteilten Krafteinleitungsflächen lässt sich relativ leicht eine gleiche Druckspannung in die Teilvolumina einbringen. Es resultiert eine Kraftvervielfachung durch eine Vergrößerung der gesamten Krafteinleitungsfläche. Zum Krafteinleiten muss eine größere Kraft aufgewendet werden. Es ist aber auch eine größere Kraft abrufbar.

In einer besonderen Ausgestaltung sind mindestens drei Krafteinleitungsflächen vorhanden, die am Oberflächenabschnitt der piezoelektrischen Schicht in einer Reihe angeordnet sind. Beispielsweise können auf diese Weise streifenförmige Krafteinleitungsflächen parallel zueinander über dem Oberflächenabschnitt verteilt sein. Denkbar ist auch, dass eine Vielzahl von punktförmigen Krafteinleitungsflächen eine Matrix aus Krafteinleitungsflächen bilden. Es resultiert damit eine entsprechende Matrix von Teilvolumina in der piezoelektrischen Schicht.

Die an einander abgekehrten Oberflächenabschnitten der piezoelektrischen Schicht angeordneten Krafteinleitungsflächen können sowohl bezüglich ihrer Form als auch bezüglich ihrer Größe unterschiedlich sein. Beispielsweise ist die Krafteinleitungsfläche eines der Oberflächenabschnitte punktförmig. Die Krafteinleitungsfläche des anderen Oberflächenabschnitts kann dagegen streifenförmig sein.
Zur Erzeugung eines sich in Dickenrichtung erstreckenden Teilvolumens weisen in einer besonderen Ausgestaltung einander abgekehrte Oberflächenabschnitte der piezoelektrischen Schicht im Wesentlichen gleich und/oder unterschiedlich geformte Krafteinleitungsflächen auf. Im Wesentlichen gleich bedeutet dabei, dass die Krafteinleitungsflächen mit einer Abweichung von bis zu 10% gleich groß sind. Unterschiedlich geformte Krafteinleitungsflächen liegen beispielsweise dann vor, wenn die Krafteinleitungsfläche des einen Oberflächenabschnitts der piezoelektrischen punktförmig und die weitere Krafteinleitungsfläche des weiteren Oberflächenabschnitts dagegen ringförmig ist. Diese Krafteinleitungsflächen sind derart übereinander angeordnet, dass die punktförmige Krafteinleitungsfläche im Zentrum der ringförmigen Krafteinleitungsfläche liegt.

In einer besonderen Ausgestaltung ist die Schichtdicke der piezoelektrischen Schicht aus dem Bereich von einschließlich 20 µm bis einschließlich 200 µm ausgewählt. Es hat sich gezeigt, dass sich bei diesen Schichtdicken auch bei Anwendung einer kleinen Kraft ein deutlich erhöhter d₃₃-Wert einstellt.

In einer besonderen Ausgestaltung weist die Krafteinleitungsfläche eine Ausdehnung auf, die im Wesentlichen der Schichtdicke der piezoelektrischen Schicht entspricht. Die Ausdehnung ist beispielsweise ein Durchmesser oder eine Kantenlänge der Krafteinleitungsfläche. Bei der oben beschriebenen Kombination aus punkt- und ringförmigen Krafteinleitungsflächen ist ein Ringdurchmesser der ringförmigen Krafteinleitungsfläche dagegen deutlich höher. Der Ringdurchmesser beträgt beispielweise 500 µm. Denkbar ist auch ein Ringdurchmesser von bis zu 1 mm.

In einer besonderen Ausgestaltung ist eine Vielzahl von Piezoelementen übereinander gestapelt. Vorzugsweise sind dabei mindestens zwei Piezoelemente derart über einander gestapelt, dass Krafteinleitungsflächen der Piezoelemente im Wesentlichen bündig übereinander angeordnet sind. Die Teilvolumina einer jeden piezoelektrischen Schicht sind in Stapelrichtung über den Teilvolumina der piezoelektrischen Schicht weiterer Piezoelemente übereinander angeordnet. Dadurch resultiert zusätzlich zur außergewöhnlichen Auslenkungshöhe eines jeden einzelnen Piezoelements ein Piezoaktor mit einer extrem hohen Auslenkung. Es resultiert eine Hubvervielfachung. Eine Kraft, die zur hohen Auslenkung in das Volumen der piezoelektrischen Schichten eingebracht werden muss, ist dabei relativ klein.

Zusammenfassend ergeben sich mit der Erfindung folgende besonderen Vorteile:
- Durch die Art der Krafteintragung in ein Teilvolumen der piezoelektrischen Schicht wird ein Piezoelement erhalten mit einem deutlich größeren Hub. Damit lässt sich beispielsweise ein Mikroaktor mit einer Bauhöhe von 1 mm und einem Hub von 10 µm realisieren.
- Bei halbem Leerlaufhub eines Mikroaktors ist dabei eine Arbeitskraft von 10 - 20 cN erzielbar.
- Kraft und mechanische Arbeit sind durch geeignet gestapelte Piezoelemente vervielfältigbar und für viele Anwendungen einstellbar.
- Durch Verbindung von piezokeramischer Vielschichttechnologie, Mikrostrukturierung und Mikromechanik bietet die Erfindung Lösungen für viele Anwendungsgebiete (Mikropumpen, Mikroventile, Mikromotoren etc.).

Anhand mehrerer Beispiele und der dazugehörigen Figuren wird die Erfindung im Folgenden näher beschrieben. Es werden einzelne Ausgestaltungen der Erfindung beschrieben, die in beliebiger Form miteinander kombiniert werden können. Die Figuren sind schematisch und stellen keine maßstabsgetreuen Abbildungen dar.
- Figuren 1 bis 7: zeigen jeweils eine Ausschnitt verschiedener Piezoaktoren im seitlichen Querschnitt.
- Figuren 8 bis 10: zeigen jeweils einen Ausschnitt einer piezoelektrischen Schicht mit Krafteinleitungsflächen in Aufsicht auf die piezoelektrische Schicht.
- Figur 11: zeigt einen Piezoaktor in perspektivischer Darstellung, bei dem eine streifenförmige Krafteinleitungsfläche realisiert ist.
- Figur 12: zeigt ein Piezoelement in Vielschichtbauweise.

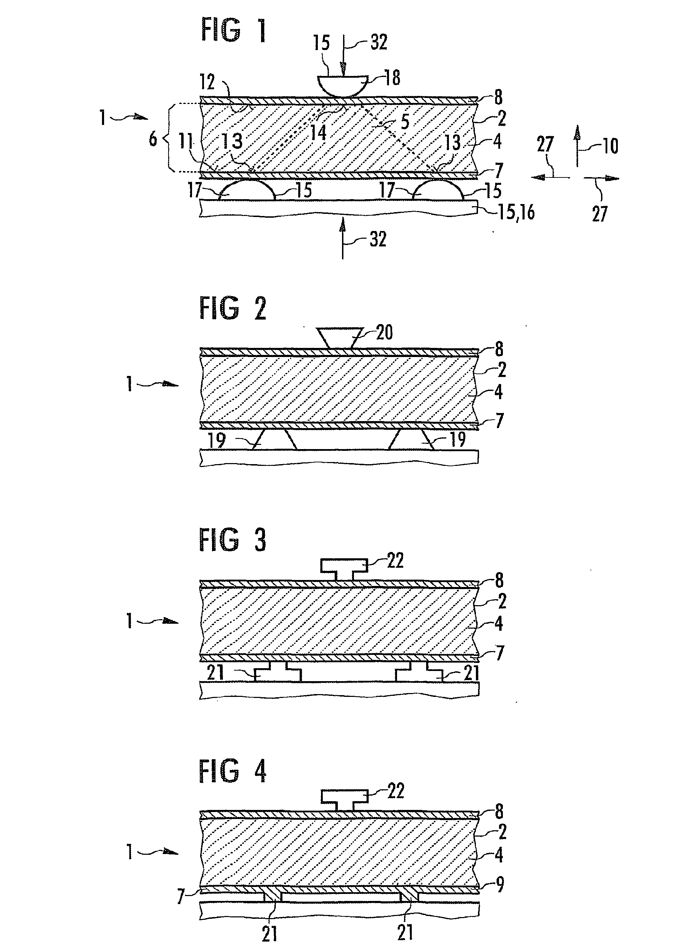

Der Piezoaktor 1 gemäß Figuren 1 bis 9 weist jeweils mindestens ein stapelförmiges Piezoelement 2 aus zwei entlang der einer Stapelrichtung 10 des Piezoelements 2 übereinander angeordneten Elektrodenschichten 7 und 8 und einer zwischen den Elektrodenschichten 7 und 8 angeordneten piezoelektrischen Schicht 4 auf. Die piezoelektrische Schicht 4 besteht aus einem Weich-PZT. Die Curietemperatur T_{C} beträgt etwa 170°C. Die Koerzitivfeldstärke Ec des Weich-PZTs liegt bei 0,5 kV/mm. Die Schichtdicke 6 der piezoelektrischen Schicht 4 beträgt etwa 120 µm.

Der Piezoaktor 1 verfügt jeweils über eine Vorspannvorrichtung 15 zur Krafteinleitung in ein Teilvolumen 5 der piezoelektrischen Schicht 4. Über die Krafteinleitungsflächen 13 und 14 wird in das Teilvolumen 5 der piezoelektrischen Schicht 4 eine Kraft 32 eingeleitet. Die Krafteinleitungsflächen 13 und 14 sind an den der Vorspannvorrichtung 15 zugekehrten Oberflächenabschnitten 11 und 12 der piezoelektrischen Schicht 4 angeordnet. Die Oberflächenabschnitte 11 und 12 sind dabei voneinander abgekehrt. Zumindest eine der Krafteinleitungsflächen 13 oder 14 ist kleiner als der zugehörige Oberflächenabschnitt 11 oder 12 der piezoelektrischen Schicht 4.

Zur Erzeugung der Krafteinleitungsflächen 13 und 14 steht die Vorspannvorrichtung 15 mit den Elektrodenschichten 7 und 8 mechanisch in Kontakt. Über die Elektrodenschichten 7 und 8 werden mittelbar die Krafteinleitungsflächen 13 und 14 der Oberflächenabschnitte 11 und 12 der piezoelektrischen Schicht 4 erzeugt. Ein Ausmaß der Krafteinleitungsflächen 13 und 14 entspricht im Wesentlichen einer jeweiligen mechanischen Kontaktfläche zwischen der Vorspannvorrichtung 15 und der entsprechenden Elektrodenschicht 7 und 8.

Die Krafteinleitungsflächen 13 und 14 sind in Stapelrichtung 19 des Piezoelements 2 derart über die piezoelektrische Schicht 4 verteilt, dass durch die Krafteinleitung eine Verbiegung des piezoelektrischen Schicht 4 hervorgerufen wird.

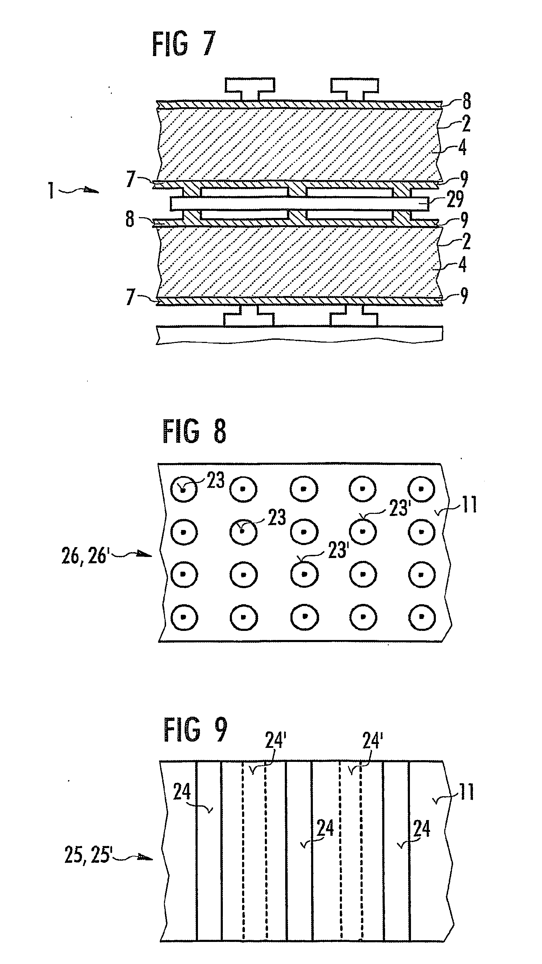

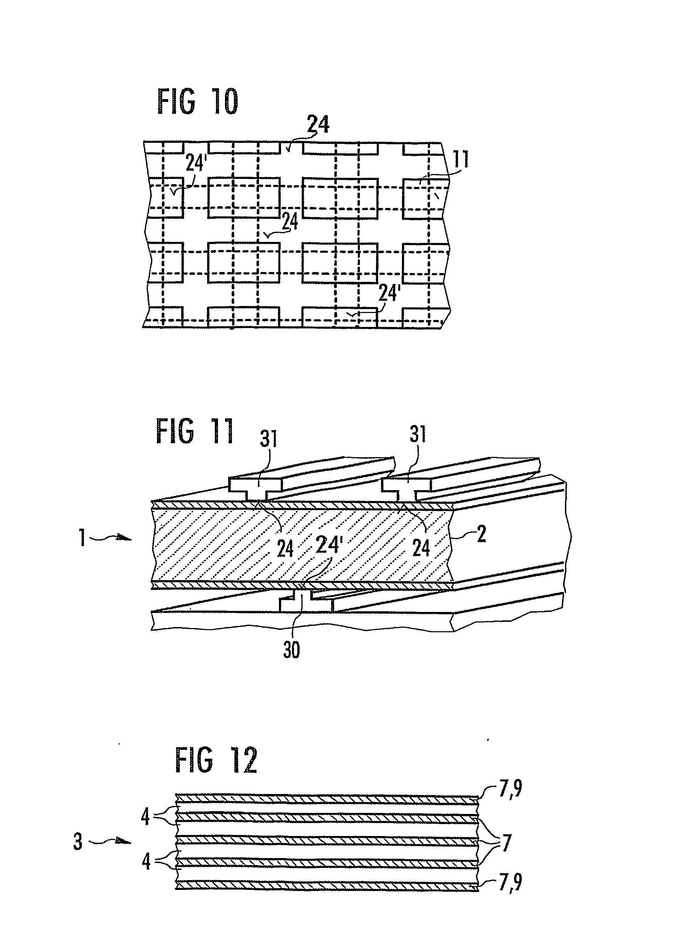

Gemäß Figur 1 verfügt die Vorspannvorrichtung 15 über mindesten eine Kugelkalotte 18 und über mindestens einen Auflagering 17 (vgl. Figur 8, Bezugszeichen 23 und 23') Der Auflagering 17 weist einen Querschnitt einer Kugelkalotte auf. Der Auflagering 17 ist mit einer Basis 16 der Vorspannvorrichtung 15 verbunden. Mit Hilfe einer nicht gezeigten Feder wird die in das Teilvolumen der piezoelektrischen Schicht 4 einzuleitende Kraft 32 auf die Kugelkalotte 18 übertragen. Der Auflagering 17 und die Kugelkalotte 18 sind einander gegenüber liegenden und mit jeweils einer der Elektrodenschichten 7 und 8 in mechanischem Kontakt stehend angeordnet. Die Kugelkalotte 18 führt zu einer punktförmigen Krafteinleitungsfläche 14. Der Durchmesser der punktförmigen Krafteinleitungsfläche beträgt etwa 50 µm. Der Auflagering 17 führt zu einer ringförmigen Krafteinleitungsfläche 13 mit einem Ringdurchmesser von etwa 500 µm. Die Kugelkalotte 18 und der Ring 17 sind dabei derart angeordnet, dass die punktförmige Krafteinleitungsfläche 14 im Zentrum der ringförmigen Krafteinleitungsfläche 13 angeordnet ist. Durch Anlegen einer Druckspannung wird über die Krafteinleitungsflächen 13 und 14 eine Kraft 32 in das Teilvolumen 5 der piezoelektrischen Schicht 4 eingeleitet. Als Folge davon kommt es in dem Teilvolumen 5 zu einem Umschalten der Polarisation 27 der Domänen quer zur Stapelrichtung 10. Das Teilvolumen 5 erstreckt sich in Stapelrichtung 10 des Piezoelements 2 entlang der gesamten Schichtdicke 6 der piezoelektrischen Schicht 4. Die Polarisation erfolgt im Teilvolumen 5 nahezu vollständig. Im Unterschied zum vorangegangenen Beispiel wird die punktförmige Krafteinleitungsfläche 14 gemäß Figur 2 mit Hilfe eines Kegelstumpfs 20 und gemäß Figur 3 mit Hilfe eines Zylinders 22 erzeugt. Der Auflagering 17 weist gemäß Figur 2 eine Querschnitt eines Kegelstumpfs 19 und gemäß Figur 3 eine Querschnitt eines Zylinders 21 auf. In einer weiteren Ausführung gemäß Figur 11 werden mit Hilfe von Quadern 30 und 31 mit rechteckiger Grundfläche streifenförmige Krafteinleitungsflächen 24 und 24' erzeugt, die in Reihe 25 bzw. 25' angeordnet sind (vgl. Figur 9).

Zum Erzeugen der Krafteinleitungsflächen verfügen gemäß Figur 4 sowohl die Vorspannvorrichtung 15 als auch das Piezoelement 2 über Zylinder 22 und 21 mit punktförmiger Grundfläche. Der Zylinder 21 des Piezoelements 2 ist dabei mit Hilfe einer strukturierten Elektrodenschicht 9 realisiert. Die Zylinder 22 der Vorspannvorrichtung 15 und die Zylinder 21 des Piezoelements 2 sind bezüglich der Stapelrichtung 10 gegeneinander versetzt. Durch Auswahl des Materials der piezoelektrischen Schicht und der Elektrodenschichten kann eine Verbiegung des Stapels ermöglicht werden. Bei Anlegen der Druckspannung kann es dabei zu einer besonders großen Huberhöhung kommen.

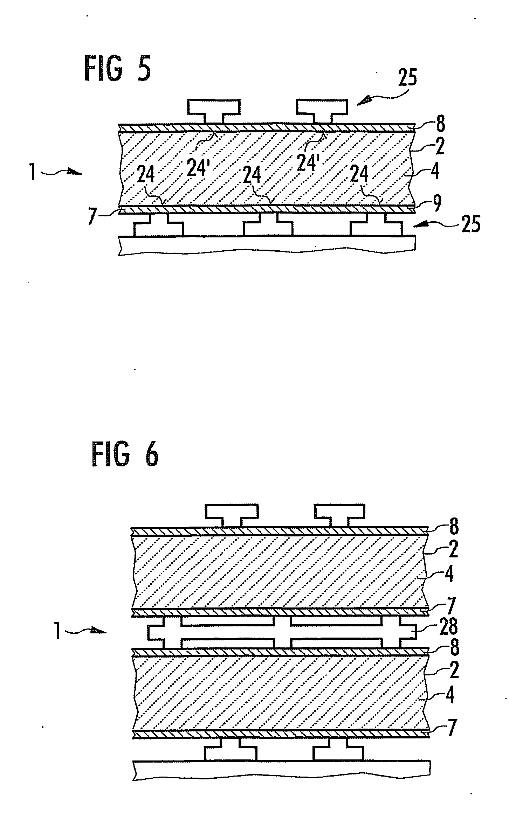

In Figur 5 ist eine weitere Ausführungsform angedeutet, bei der mehrere Zylinder zu den Oberflächenabschnitten 11 und 12 in Reihe 25 angeordnet sind. Wenn die Grundflächen der Zylinder streifenförmig sind, resultieren streifenförmige Krafteinleitungsflächen 24 und 24' (Figur 9). Die Krafteinleitungsflächen 24 und 24' sind gegeneinander versetzt. Figur 10 stellt eine Variante der streifenförmigen Krafteinleitungsflächen 24 und 24' dar. Die streifenförmigen Krafteinleitungsflächen 24 und 24' sind jeweils quer zur Längsrichtung der Streifen über Stege miteinander verbunden.

Die Krafteinleitung in die piezoelektrische Schicht 4 erfolgt netzartig.

Eine weitere Ausführungsform ist in Figur 8 dargestellt. Eine Vielzahl von punktförmigen Krafteinleitungsflächen 23 ist über einen Oberflächenabschnitt 11 und eine Vielzahl von ringförmigen Krafteinleitungsflächen 23' über den weiteren Oberflächenabschnitt 12 der piezoelektrischen Schicht 4 jeweils in Form einer Matrix 26 und 26' verteilt.

Die Figuren 6 und 7 zeigen zwei Ausführungsbeispiele, bei denen zwei Piezoelemente 2 derart gestapelt sind, dass die Krafteinleitungsflächen 13, 14 der Piezoelemente 2 bündig übereinander angeordnet sind. Zur Krafteinleitung in die piezoelektrischen Schichten 2 ist gemäß Figur 6 zwischen den Piezoelementen 2 eine strukturierte Metallfolie 28 eingebracht. Figur 7 stellt dagegen einer Erweiterung des Ausführungsbeispiels gemäß Figur 4 dar. Zur Krafteinleitung weisen die Elektrodenschichten 9 zumindest zum Teil Zylinder auf. Die Elektrodenschichten 9 sind strukturiert. Zur Anpassung eines Kraftschlusses ist zwischen den strukturierten Elektrodenschichten 9 der gestapelten Piezoelemente 2 eine Metallzwischenfolie 29 angeordnet.

Weitere Ausführungsformen ergeben sich dadurch, dass Piezoelemente 3 in Vielschichtbauweise verwendet werden, bei denen mehrere Elektrodenschichten 7 und piezoelektrische Schichten 4 übereinander abwechselnd angeordnet sind (Figur 12). Gemäß einer weiteren Ausführungsform sind die äußeren Elektrodenschichten 7 strukturierte Elektrodenschichten 9.

Basierend auf dem Piezoaktor 1 gemäß Figur 1 wurden die in Tabelle 1 aufgeführten Messergebnisse erzielt. Das Piezoelement 2 wurde mit einer statischen Kraft von 0,7 N, beaufschlagt. Bei einer elektrischen Feldstärke von 1kV/mm wurde die piezoelektrische Ladungskonstante d₃₃ als Funktion des piezokeramischen Materials und der Schichtdicke 6 der piezoelektrischen Schicht 4 ermittelt. Es sind d₃₃-Werte von bis zu 15.000 pm/V erzielbar.

**Tabelle 1:**

| **Versuch Nr. 1** | **Piezokeramik** | **Curie-Temperatur** | **Koerzitiv-feldstärke** | **Probendicke** | **d₃₃** |
|---|---|---|---|---|---|
| | | [°C] | [kV/mm] | [µm] | [pm/V] |
| 1 | Weich-PZT | 330 | 1.0 | 1000 | 650 |
| 2 | Weich-PZT | 330 | 1.0 | 110 | 2200 |
| 3 | Weich-PZT | 170 | 0.5 | 1000 | 1150 |
| 4 | Weich-PZT | 170 | 0.5 | 260 | 1600 |
| 5 | Weich-PZT | 170 | 0.5 | 120 | 15000 |
| 6 | Weich-PZT | 120 | 0.3 | 1000 | 1400 |
| 7 | Weich-PZT | 120 | 0.3 | 160 | 3500 |

## Patentansprüche

1. Piezoaktor (1) mit
- mindestens einem stapelförmigen Piezoelement (2), das mindestens zwei entlang einer Stapelrichtung (10) des Piezoelements (2) übereinander angeordnete Elektrodenschichten (7, 8, 9) und mindestens eine jeweils zwischen zwei Elektrodenschichten (7, 8, 9) angeordnete piezoelektrische Schicht (4) aufweist, und
- mindestens einer Vorspannvorrichtung (15) zur Krafteinleitung (32) in ein Volumen der piezoelektrischen Schicht (4) über mindestens eine Krafteinleitungsfläche (13, 14, 23, 24) der piezoelektrischen Schicht (4), die an mindestens einem der Vorspannvorrichtung (15) zugekehrten Oberflächenabschnitt (11, 12) der piezoelektrischen Schicht (4) angeordnet ist,
**dadurch gekennzeichnet, dass**
- die Krafteinleitungsfläche (13, 14, 23, 24) kleiner ist als der Oberflächenabschnitt (11, 12) der piezoelektrischen Schicht (4) und das Volumen ein Teilvolumen (5) der piezoelektrischen Schicht (4) ist.

2. Piezoaktor nach Anspruch 1, wobei mehrere Krafteinleitungsflächen (13, 14) derart über die piezoelektrische Schicht (4) verteilt sind, dass es durch die Krafteinleitung zu einer Verbiegung der piezoelektrischen Schicht (4) kommt.

3. Piezoaktor nach Anspruch 1 oder 2, wobei die piezoelektrische Schicht (4) einen Oberflächenabschnitt (11) mit mindestens einer Krafteinleitungsfläche (13) und einen dem Oberflächenabschnitt (11) abgewandten, weiteren Oberflächenabschnitt (12) mit mindestens einer weiteren Krafteinleitungsfläche (14) aufweist und die Krafteinleitungsflächen (13, 14) bezüglich der Stapelrichtung (10) des Piezoelements (2) gegeneinander seitlich versetzt sind.

4. Piezoaktor nach einem der Ansprüche 1 bis 3, wobei die Vorspannvorrichtung (15) und/oder das Piezoelement (2) zur Erzeugung der Krafteinleitungsfläche (13, 14, 23, 24) mindestens eine aus der Gruppe Kugelkalotte ( 18), Kegelstumpf (19, 29), Quader (30, 31) Ring (17) und/oder Zylinder (21, 22) ausgewählte Bauform aufweisen.

5. Piezoaktor nach einem der Ansprüche 1 bis 4, wobei die Krafteinleitungsfläche (23) punktförmig ist.

6. Piezoaktor nach einem der Ansprüche 1 bis 4, wobei die Krafteinleitungsfläche (24, 24') streifenförmig ist.

7. Piezoaktor nach einem der Ansprüche 1 bis 4, wobei die Krafteinleitungsfläche (23') ringförmig ist.

8. Piezoaktor nach einem der Ansprüche 1 bis 7, wobei mindestens drei Krafteinleitungsflächen vorhanden sind, die über den Oberflächenabschnitt (11, 12) der piezoelektrischen Schicht (4) flächig verteilt sind.

9. Piezoaktor nach Anspruch 1 bis 8, wobei mindestens drei Krafteinleitungsflächen vorhanden sind, die am Oberflächenabschnitt (11, 12) der piezoelektrischen Schicht (4) in Reihe (25) angeordnet sind.

10. Piezoaktor nach einem der Ansprüche 1 bis 9, wobei einander abgekehrte Oberflächenabschnitte (.11, 12) der piezoelektrischen Schicht (4) gleiche und/oder unterschiedlich geformte Krafteinleitungsflächen (13, 14, 23, 24) aufweisen, die entlang der Stapelrichtung (10) gegeneinander versetzt angeordnet sind.

11. Piezoaktor nach einem der Ansprüche 1 bis 10, wobei eine Schichtdicke (6) der piezoelektrischen Schicht (4) aus dem Bereich von einschließlich 20 µm bis einschließlich 200 µm ausgewählt ist.

12. Piezoaktor nach Anspruch 11, wobei die Krafteinleitungsfläche (13, 14, 23, 24) eine Ausdehnung aufweist, die im Wesentlichen der Schichtdicke (6) der piezoelektrischen Schicht (4) entspricht.

13. Piezoaktor nach einem der Ansprüche 1 bis 12, wobei eine Vielzahl von Piezoelementen (2) übereinander gestapelt ist.

14. Piezoaktor nach Anspruch 13, wobei mindestens zwei Piezoelemente (2) derart übereinander gestapelt sind, dass Krafteinleitungsflächen (13, 14, 23, 24) der Piezoelemente (2) im Wesentlichen bündig übereinander angeordnet sind.

15. Verfahren zum Herstellen eines Piezoaktors (2) nach einem der Ansprüche 1 bis 14 durch Einleiten einer Kraft (32) in ein Teilvolumen (5) der piezoelektrischen Schicht (4) über die Krafteinleitungsfläche (13, 14, 23, 24) der piezoelektrischen Schicht (4) derart, dass in dem Teilvolumen (5) der piezoelektrischen Schicht eine Polarisation (27) quer zur Stapelrichtung (10) erzeugt wird.

16. Verfahren nach Anspruch 15, wobei ein Teilvolumen (5) verwendet wird, das sich entlang einer gesamten Schichtdicke (6) der piezoelektrischen Schicht (4) erstreckt.

17. Verfahren nach Anspruch 15 oder 16, wobei im Teilvolumen (5) eine im Wesentlichen vollständige Polarisation quer zur Stapelrichtung (10) erzeugt wird.

## Claims

1. Piezoactuator (1) comprising
- at least one stacked piezoelement (2), with at least two electrode layers (7, 8, 9), arranged one over the other along a stacking direction (10) of the piezoelement (2), and at least one piezoelectric layer (4), arranged between two electrode layers (7, 8, 9), and
- at least one pretensioning device (15) for introduction of force (32) into a volume of the piezoelectric layer (4) by means of at least one force introduction surface (13, 14, 23, 24) on the piezoelectric layer (4), which is arranged on at least one of the surface sections (11, 12) of the piezoelectric layer (4) so that it faces the pretensioning device (15),
**characterised in that**
- the force introduction surface (13, 14, 23, 24) is smaller than the surface section (11, 12) of the piezoelectric layer (4) and that the volume is a partial volume (5) of the piezoelectric layer (4).

2. Piezoactuator according to claim 1,
in which a plurality of force introduction surfaces (13, 14) are distributed over the piezoelectric layer (4) in such a way that the introduction of force causes a bending of the piezoelectric layer (4).

3. Piezoactuator according to claim 1 or 2,
in which the piezoelectric layer (4) comprises a surface section (11) having at least one force introduction surface (13), and a further surface section (12) facing away from the surface section (11) and having at least one further force introduction surface (14), and in which the force introduction surfaces (13, 14) are laterally offset from one another relative to the stacking direction (10) of the piezoelement (2).

4. Piezoactuator according to one of claims 1 to 3,
in which at least one of the designs chosen for the pretensioning device (15) and/or piezoelement (2) for generating the force introduction surface (13, 14, 23, 24) takes the form of a spherical cup (18), frustum of a cone (19, 29), cuboid (30, 31), ring (17) and/or cylinder (21, 22).

5. Piezoactuator according to one of claims 1 to 4, in which the force introduction surface (23) is point-like.

6. Piezoactuator according to one of Claims 1 to 4, in which the force introduction surface (24, 24') is stripe-shaped.

7. Piezoactuator according to one of Claims 1 to 4, in which the force introduction surface (23') is ring-shaped.

8. Piezoactuator according to one of claims 1 to 7,
in which there are at least three force introduction surfaces, evenly distributed over the surface section (11, 12) of the piezoelectric layer (4).

9. Piezoactuator according to claims 1 or 8,
in which there are at least three force introduction surfaces, arranged in a row (25) on the surface section (11, 12) of the piezoelectric layer (4).

10. Piezoactuator according to one of claims 1 to 9,
in which surface sections (11, 12) of the piezoelectric layer (4) which face away from one another have identical and/or differently shaped force introduction surfaces (13, 14, 23, 24) arranged along the stacking direction (10) and offset from one another.

11. Piezoactuator according to one of the claims 1 to 10, in which a thickness (6) selected for the piezoelectric layer (4) is in the range 20 µm to 200 µm inclusive.

12. Piezoactuator according to claim 11,
in which an extent of the force introduction surface (13, 14, 23, 24) virtually corresponds to the thickness (6) of the piezoelectric layer (4).

13. Piezoactuator according to one of claims 1 to 12, in which a plurality of piezoelements (2) are stacked one over the other.

14. Piezoactuator according to claim 13,
in which at least two piezoelements (2) are stacked over one another in such a way that force introduction surfaces (13, 14, 23, 24) of the piezoelements (2) are arranged more or less flush one over the other.

15. Method for producing a piezoactuator (2) according to one of claims 1 to 14 by introducing a force (32) into a partial volume (5) of the piezoelectric layer (4) via the force introduction surface (13, 14, 23, 24) of the piezoelectric layer (4) in such a way that, in the partial volume (5) of the piezoelectric layer, a polarisation (27) is generated transverse to the stacking direction (10).

16. Method according to claim 15, in which a partial volume (5) extending along an entire thickness (6) of the piezoelectric layer (4) is used.

17. Method according to claim 15 or 16, in which virtually complete polarisation transverse to the stacking direction (10) is generated in the partial volume (5).

## Revendications

1. Actionneur piézoélectrique (1) comprenant
- au moins un élément piézoélectrique (2) qui se présente sous la forme d'un empilement et comporte au moins deux couches d'électrodes (7, 8, 9) qui se superposent le long d'un sens d'empilement (10) de l'élément piézoélectrique (2) et au moins une couche piézoélectrique (4) située respectivement entre deux couches d'électrodes (7, 8, 9), et
- au moins un dispositif de précontrainte (15) pour introduire une force (32) dans un volume de la couche piézoélectrique (4) par au moins une surface d'introduction de force (13, 14, 23, 24) de la couche piézoélectrique (4), laquelle est située sur au moins une section de la surface (11, 12) de la couche piézoélectrique (4) tournée vers le dispositif de précontrainte (15),
**caractérisé en ce que**
- la surface d'introduction de force (13, 14, 23, 24) est inférieure à la section de surface (11, 12) de la couche piézoélectrique (4) et le volume est un volume partiel (5) de la couche piézoélectrique (4).

2. Actionneur piézoélectrique selon la revendication 1, plusieurs surfaces d'introduction de force (13, 14) étant réparties de manière telle sur la couche piézoélectrique (4) que, du fait de l'introduction de la force, il se produit une déformation de la couche piézoélectrique (4).

3. Actionneur piézoélectrique selon la revendication 1 ou 2, la couche piézoélectrique (4) présentant une section de surface (11) avec au moins une surface d'introduction de force (13) et une autre section de surface (12) non tournée vers la section de surface (11) avec au moins une autre surface d'introduction de force (14) et les surfaces d'introduction de force (13, 14) étant en quinconce latérale les unes par rapport aux autres par rapport au sens de l'empilement (10) de l'élément piézoélectrique (2).

4. Actionneur piézoélectrique selon l'une des revendications 1 à 3, le dispositif de précontrainte (15) et/ou l'élément piézoélectrique (2), pour générer la surface d'introduction de force (13, 14, 23, 24), présentant au moins une forme de construction choisie dans le groupe calotte sphérique (18), cône tronqué (19, 29), bloc rectangulaire (30, 31), anneau (17) et/ou cylindre (21, 22).

5. Actionneur piézoélectrique selon l'une des revendications 1 à 4, la surface d'introduction de force (23) étant ponctuelle.

6. Actionneur piézoélectrique selon l'une des revendications 1 à 4, la surface d'introduction de force (24, 24') étant en forme de bande.

7. Actionneur piézoélectrique selon l'une des revendications 1 à 4, la surface d'introduction de force (23') étant annulaire.

8. Actionneur piézoélectrique selon l'une des revendications 1 à 7, au moins trois surfaces d'introduction de force étant présentes, lesquelles sont réparties de manière plane sur la section de surface (11, 12) de la couche piézoélectrique (4).

9. Actionneur piézoélectrique selon l'une des revendications 1 à 8, au moins trois surfaces d'introduction de force étant présentes, lesquelles sont disposées en une rangée (25) sur la section de surface (11, 12) de la couche piézoélectrique (4).

10. Actionneur piézoélectrique selon l'une des revendications 1 à 9, des sections de surface opposées l'une à l'autre (11, 12) de la couche piézoélectrique (4) présentant des surfaces d'introduction de force (13, 14, 23, 24) de forme identique et/ou différente, lesquelles sont disposées en quinconce les uns par rapport aux autres le long du sens de l'empilement (10).

11. Actionneur piézoélectrique selon l'une des revendications 1 à 10, une épaisseur de couche (6) de la couche piézoélectrique (4) étant choisie dans la plage allant de 20 µm inclus à 200 µm inclus.

12. Actionneur piézoélectrique selon la revendication 11, la surface d'introduction de force (13, 14, 23, 24) présentant une étendue qui correspond sensiblement à l'épaisseur de couche (6) de la couche piézoélectrique (4).

13. Actionneur piézoélectrique selon l'une des revendications 1 à 12, une pluralité d'éléments piézoélectriques (2) étant empilés les uns sur les autres.

14. Actionneur piézoélectrique selon la revendication 13, au moins deux éléments piézoélectriques (2) étant empilés de manière telle l'un sur l'autre que des surfaces d'introduction de force (13, 14, 23, 24) des éléments piézoélectriques (2) sont superposés de manière sensiblement alignée.

15. Procédé de fabrication d'un actionneur piézoélectrique (2) selon l'une des revendications 1 à 14 par introduction d'une force (32) dans un volume partiel (5) de la couche piézoélectrique (4) par la surface d'introduction de forces (13, 14, 23, 24) de la couche piézoélectrique (4) de manière telle que, dans le volume partiel (5) de la couche piézoélectrique, on génère une polarisation (27) transversalement par rapport au sens de l'empilement (10).

16. Procédé selon la revendication 15, un volume partiel (5) étant utilisé, lequel s'étend le long de toute une épaisseur de couche (6) de la couche piézoélectrique (4).

17. Procédé selon la revendication 15 ou 16, une polarisation sensiblement complète étant générée, dans le volume partiel (5), transversalement par rapport au sens de l'empilement (10).
